# EUROPEAN PATENT APPLICATION

(11) **EP 1 875 944 A1**
(43) Date of publication of application: **09.01.2008**
(21) Application number: 06022323.7
(22) Date of filing: 25.10.2006
(51) Int. Cl.: A63B 37/12

(54) **Golf ball**

(30) Priority: 07.07.2006 JP 2006005465
(71) Applicant: John's Electrode MFG. Co., Ltd., Kaohsiung City (TW)
(72) Inventor: Lin, Stuart, Kaohsiung City (TW)
(74) Representative: Hartz, Nikolai

(57) **Abstract**

A golf ball aims to facilitate discerning of flying distance of a hitting golf ball for golfers. It has a solid ball inside, a reflective layer coated on the surface of the solid ball and a transparent layer formed on the reflective layer. When the golf ball is hit and flies, the layer structure of the reflective layer and transparent layer can reflect light projecting thereon so that the golf ball looks brighter, and the golfers can clearly see the flying distance and dropping location of the golf ball.

## Description

### FIELD OF THE INVENTION

The present invention relates to a golf ball and particularly to a golf ball coated a reflective layer and a transparent layer on the surface of the solid ball so that the golfers can clearly see the flying distance and dropping location of the golf ball.

### BACKGROUND OF THE INVENTION

Golf becomes an increasingly popular sport in recent years affordable to many people. Many golf courses have been constructed and are accessible to the general public. Golf outfits such as golf clubs and golf balls are also widely available on the domestic and international markets. Competition of those products is intense. How to develop products with unique features is one of important factors to gain competitive edge in the market place. Meanwhile the traditional white golf ball can no longer satisfy capricious consumers. Hence aside from the white golf ball, now there are also golf balls formed with various patterns. In addition to satisfying golfer's fancy, special patterns also reveal golfer's taste and social station, and even become collection items.

However, the golf ball basically still is made by injection to form the outer layer. The core of the ball is formed by winding or solid. Whatever the composition of the core or outer layer, the traditional final process is to coat a polishing material on the surface of the ball for emblazonment.

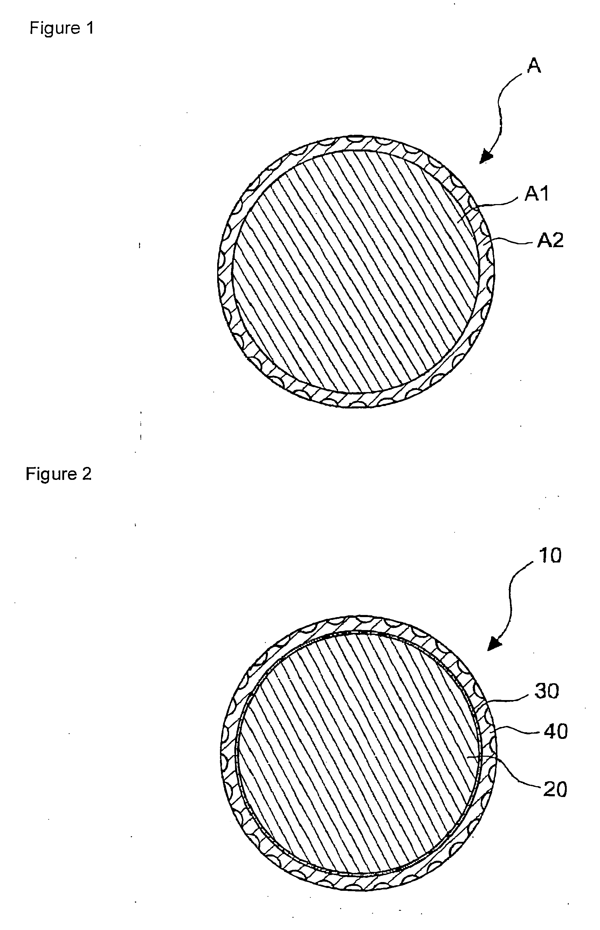

The final process is delicate and complicated. The conventional white golf ball A (referring to FIG. 1) has a ball A1 and a white layer A2 on the surface of the ball A1. When the golf ball A is hit, due to the white layer A2 is not bright enough, the fly distance and dropping spot of the golf ball A are difficult to discern by golfers.

### SUMMARY OF THE INVENTION

In view of the aforesaid problem the primary object of the present invention is to provide an improved golf ball to facilitate discerning of flying distance and dropping location of the golf ball. It also provides a special three dimensional effect.

To achieve the foregoing objects, the invention provides a golf ball that has a solid ball as a core and a surface coated with a reflective layer, and a transparent layer formed on the reflective layer. When the golf ball is hit, the layer structure of the reflective layer and outmost transparent layer can reflect light projecting thereon to make the reflective layer on the surface of the golf ball brighter.

In summary, by providing the reflective layer and transparent layer on the golf ball, the invention can achieve the following effects:
1. Facilitate golf ball flying: With a reflective layer coating on the surface of a solid ball and a transparent layer forming on the reflective layer to form a layer structure, upon light projection the golf ball looks brighter. Hence golfers can see clearer the flying distance and dropping location of the golf ball.
2. Provide excellent reflective function: Because of the reflective layer and transparent layer formed on the surface of the ball, an excellent reflective effect can be generated upon light projection. The golf ball looks brighter.

The foregoing, as well as additional objects, features and advantages of the invention will be more readily apparent from the following detailed description, which proceeds with reference to the accompanying drawings.

### BRIEF DESCRIPTION OF THE DRAWINGS

FIG. 1 is a sectional view of a conventional golf ball.
FIG. 2 is a sectional view of the golf ball of the invention.
FIG. 3 is a sectional view of another embodiment of the transparent layer of the invention.
FIG. 4 is a fragmentary enlarged view according to FIG. 3.

### DETAILED DESCRIPTION OF THE PREFERRED EMBODIMENTS

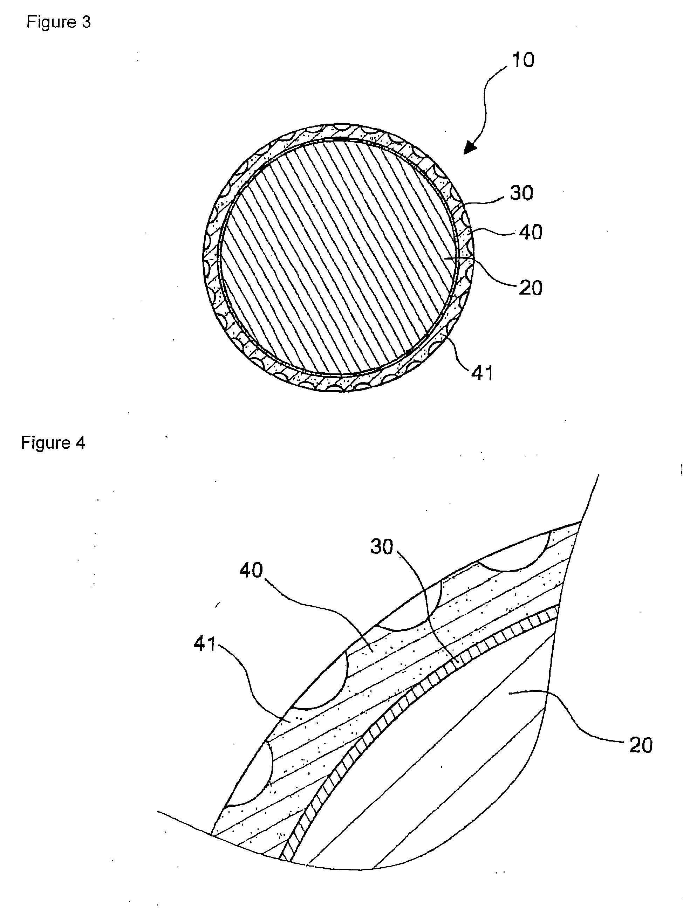

Please refer to FIG. 2, a golf ball 10 according to the invention mainly includes a solid ball 20, a reflective layer 30 and a transparent layer 40. The reflective layer 30 is coated on the surface of the solid ball 20. The transparent layer 40 is formed on the surface of the reflective layer 30.

Referring to FIGS. 3 and 4, the transparent layer 40 may contain fluorescent powders 41. Hence during flying of the golf ball 10, light projection on the golf ball 10 can be reflected by the reflective layer 30 and the transparent layer 40 that contains the fluorescent powders 41 to make the golf ball 10 looking brighter.

The reflective layer 30 is a thin layer as shown in the drawings.

When in use, referring to FIG. 2, the golf ball 10 is hit and flies. Light projected onto the ball is reflected by the reflective layer 30 on the surface of the solid ball 20, and emits through the transparent layer 40. Thus the golf ball 10 looks brighter. The flying distance and dropping location of the golf ball 10 can be seen clearer by the golfers.

In short, the golf ball 10 of the invention provides the following main features:
1. When golfers strike the golf ball 10, the middle reflective layer 30 on the golf ball 10 performs light reflection. After the golf ball 10 is hit and flies, through the layer structure of the reflective layer 30 and transparent layer 40 formed on the surface 20 of the solid ball 20, light projecting thereon can be reflected to give the golfers clearer view of the flying distance and dropping location of the golf ball 10.
2. The reflective layer 30 and transparent layer 40 formed on the surface of the solid ball 20 give the entire golf ball 10 a brighter look and more appealing visual effect, thus increase the economic value of the golf ball 10.

Therefore the golf ball 10 of the invention provides new and desirable functions that are more appealing to golfers. The flying distance and dropping location of the golf ball 10 are more discernable to the golfers. It also has an excellent reflective effect, and can whet golfers' purchase desire.

## Claims

1. A golf ball comprising a solid ball, a reflective layer coated on the surface of the solid ball and a transparent layer formed on the reflective layer.

2. The golf ball of claim 1, wherein the reflective layer is a thin film.

3. The golf ball of claim 1, wherein the transparent layer contains fluorescent powders.
